# EUROPEAN PATENT APPLICATION

(11) **EP 4 246 391 A1**
(43) Date of publication of application: **20.09.2023**
(21) Application number: 20961403.1
(22) Date of filing: 15.12.2020
(51) Int. Cl.: G06Q 10/04

(54) **RAIL TRAFFIC PARALLEL DEDUCTION SYSTEM AND METHOD**

(30) Priority: 10.11.2020 CN 202011249711
(71) Applicant: Traffic Control Technology Co., Ltd., Beijing 100070 (CN)
(72) Inventor: XI, Hongchang, Beijing 100070 (CN); SUN, Junguo, Beijing 100070 (CN); LIU, Chao, Beijing 100070 (CN)
(74) Representative: Micheli & Cie SA
(86) International application number: PCT/CN2020/136365
(87) International publication number: WO 2022/099849

(57) **Abstract**

A rail traffic parallel deduction system and method. The system comprising: a data acquisition module (110) used for acquiring real-time train operation data and real-time passenger flow data on a target line; a line network passenger flow change early warning module (120) used for calculating, on the basis of past passenger flow data and the real-time passenger flow data of the target line, real-time passenger flow temporal and spatial distributions corresponding to the target line to predict the passenger flow of the target line; a failure event impact analysis module (130) used for determining the impact of a sudden failure on line operation; and a handling plan deduction calculation module (140) used for performing deduction on different handling plans for sudden large passenger flow, sudden failures, or emergency events to determine the impact of each handling plan on the train operation, passenger flow, and traffic flow of the target line, and performing energy consumption analysis. By acquiring operation status from the real world in real time, the present system can quickly deduce, on the basis of inputs of real-time data and real-time plans, the future operation status of a line in different scenarios and different plans and provide indicator data, thereby providing scientific support for real-time scheduling decisions.

## Description

### CROSS-REFERENCE TO RELATED APPLICATION

The present application claims priority to Chinese patent application No. 202011249711.4, filed on November 10, 2020, entitled "Rail Traffic Parallel Deduction System and Method", which is hereby incorporated by reference in its entirety.

### FIELD

The present application relates to the field of rail transit technologies, and in particular to a system and a method for rail transit parallel deduction.

### BACKGROUND

When performing organization and operation of rail transit, plans need to be made in advance. The plans are made based on historical data and forecast data. If there are emergencies or failures, a dispatcher copes with the emergencies or failures only based on his personal experience.

A traditional rail transit operation mode has such shortcomings as: 1) no strategies for coping emergencies, for example, after an emergency occurs, an operation scheme organized by a dispatcher cannot perfectly match passenger flow; 2) insufficient analysis on an impact of a sudden failure, for example, the dispatcher determines an impact of a line failure on operation, such as a scope of a fault point and a duration of the impact, only based on personal experience; 3) being lacking of scientific basis for emergency response, for example, under emergency conditions, the dispatcher needs to make decisions in a short time, and the dispatcher generally makes schemes and determines pros and cons of different schemes based on personal experience; 4) a mismatch between operation plans and actual situations on site, for example, the operation plans are often made in advance, resulting in deviation from actual scenes.

### SUMMARY

Embodiments of the present application provide a system and a method for rail transit parallel deduction, to solve the problem that in a traditional rail transit operation mode, a dispatcher copes with emergencies or failures only based on his personal experience, resulting in deviation from actual scenes.

An embodiment of the present application provides a system for rail transit parallel deduction, including:
a data obtaining module, used to obtain real-time train operation data and real-time passenger flow data for a target line;
a network passenger flow change early warning module, used to calculate real-time passenger flow spatial-temporal distribution corresponding to the target line based on historical passenger flow data and the real-time passenger flow data for the target line, and predict a passenger flow situation for the target line based on the real-time passenger flow spatial-temporal distribution;
a failure event impact analyzing module, used to, in case that a sudden failure occurs for the target line, determine an impact of the sudden failure on line operation and output index data associated with driving operation; and
a disposal scheme deduction calculating module, used to, in case that a sudden large passenger flow, a sudden failure or an emergency event occurs for the target line, deduce different disposal schemes for the sudden large passenger flow, the sudden failure or the emergency event, determine impacts of each disposal scheme on driving operation, passenger flow and traffic flow for the target line, perform energy consumption analysis, and output indexing data corresponding to each disposal scheme.

In an embodiment, according to the system for rail transit parallel deduction of an embodiment of the present application, the disposal scheme deduction calculating module includes:
an operation simulating sub-module, used to, based on a disposal scheme inputted by a user or other systems, real-time train operation data and a train operation model, gradually deduce in terms of a preset time period, the index data associated with driving operation corresponding to a next preset time period for the target line under a current disposal scheme;
a passenger flow simulating sub-module, used to, based on a disposal scheme inputted by a user or other systems, real-time train operation data and a passenger flow stimulating model, gradually deduce in terms of a preset time period, the index data associated with passenger flow corresponding to a next preset time period for the target line under the current disposal scheme; and
an energy consumption analyzing sub-module, used to, based on a disposal scheme inputted by a user or other systems, real-time train operation data and an energy consumption model, gradually deduce in terms of a preset time period, energy consumption index data corresponding to a next preset time period for the target line under the current disposal scheme.

In an embodiment, according to the system for rail transit parallel deduction of an embodiment of the present application, the disposal scheme deduction calculating module further includes:
an indicator evaluation sub-module, used to, based on the indexing data corresponding to each disposal scheme and index data for operation demand, evaluate each disposal scheme and output evaluation results corresponding to each disposal scheme.

In an embodiment, the system for rail transit parallel deduction according to an embodiment of the present application further includes:
a user interface module, used to interact with the user;
a data storage module, used to store the real-time train operation data, the real-time passenger flow data, disposal schemes and model data; and
a scheme managing module, used to manage the disposal schemes.

An embodiment of the present application provides a method for rail transit parallel deduction, including:
obtaining real-time train operation data and real-time passenger flow data for a target line;
calculating real-time passenger flow spatial-temporal distribution corresponding to the target line based on historical passenger flow data and the real-time passenger flow data for the target line, and predicting a passenger flow situation for the target line based on the real-time passenger flow spatial-temporal distribution;
in case that a sudden failure occurs for the target line, determining an impact of the sudden failure on line operation and outputting index data associated with driving operation; and
in case that a sudden large passenger flow, a sudden failure or an emergency event occurs for the target line, deducing different disposal schemes for the sudden large passenger flow, the sudden failure or the emergency event, determining impacts of each disposal scheme on driving operation, passenger flow and traffic flow for the target line, performing energy consumption analysis, and outputting the indexing data corresponding to each disposal scheme.

In an embodiment, according to the method for rail transit parallel deduction of an embodiment of the present application, the in case that the sudden large passenger flow, the sudden failure or the emergency event occurs for the target line, deducing different disposal schemes for the sudden large passenger flow, the sudden failure or the emergency event, determining impacts of each disposal scheme on driving operation, passenger flow and traffic flow for the target line, performing energy consumption analysis, and outputting indexing data corresponding to each disposal scheme, includes:
based on a disposal scheme inputted by a user or other systems, real-time train operation data and a train operation model, gradually deducing in terms of a preset time period, the index data associated with driving operation corresponding to a next preset time period for the target line under a current disposal scheme;
based on a disposal scheme inputted by a user or other systems, real-time train operation data and a passenger flow stimulating model, gradually deducing in terms of a preset time period, the index data associated with passenger flow corresponding to a next preset time period for the target line under the current disposal scheme; and
based on a disposal scheme inputted by a user or other systems, real-time train operation data and an energy consumption model, gradually deducing in terms of a preset time period, energy consumption index data corresponding to a next preset time period for the target line under the current disposal scheme.

In an embodiment, the method for rail transit parallel deduction according to an embodiment of the present application further includes:
based on the indexing data corresponding to each disposal scheme and index data for operation demand, evaluating each disposal scheme and outputting evaluation results corresponding to each disposal scheme.

An embodiment of the present application provides an electronic device, including a memory, a processor, and a computer program stored on the memory and executable on the processor, where the computer program, when executed by the processor, causes the electronic device to execute steps of the above method for rail transit parallel deduction.

An embodiment of the present application provides a non-transitory computer-readable storage medium, having a computer program stored thereon, and the computer program, when executed by a processor, causes the processor to execute steps of the above method for rail transit parallel deduction.

In the system and method for rail transit parallel deduction according to the embodiments of the present application, by collecting operation states from real world in real time, quickly deducing future operation states of lines under different scenes and different schemes based on the input of real-time data and real-time solutions, and outputting index data, a scientific support for real-time scheduling decisions can be provided.

### BRIEF DESCRIPTION OF DRAWINGS

In order to illustrate solutions in embodiments of the present application or the related art, the following briefly introduces drawings that need to be used in the description of the embodiments of the present application or the related art. The described drawings in the following are some embodiments of the present application, and those of ordinary skill in the art can obtain other drawings based on these described drawings without creative work.
FIG. 1 is a schematic structural diagram of a system for rail transit parallel deduction according to an embodiment of the present application;
FIG. 2 is a schematic flow chart of a method for rail transit parallel deduction according to an embodiment of the present application; and
FIG. 3 is a schematic diagram of a physical structure of an electronic device according to an embodiment of the present application.

### DETAILED DESCRIPTION OF THE EMBODIMENTS

In order to illustrate the objectives, solutions and advantages of the present application, solutions in the embodiments of the present application are described clearly and completely below in combination with the drawings in the embodiments of the present application. The described embodiments are part of the embodiments of the present application, not all embodiments. Based on the embodiments of the present application, all other embodiments obtained by those of ordinary skill in the art without creative work are within the protection scope of the present application.

When performing organization and operation of rail transit, plans need to be made in advance. The plans are made based on historical data and forecast data. If there are emergencies or failures, a dispatcher copes with that the emergencies or failures only based on their personal experience. In order to solve the problem that in a traditional rail transit operation mode, a dispatcher copes with emergencies or failures only based on his personal experience, resulting in deviation from actual scenes, embodiments of the present application provide a system and a method for rail transit parallel deduction.

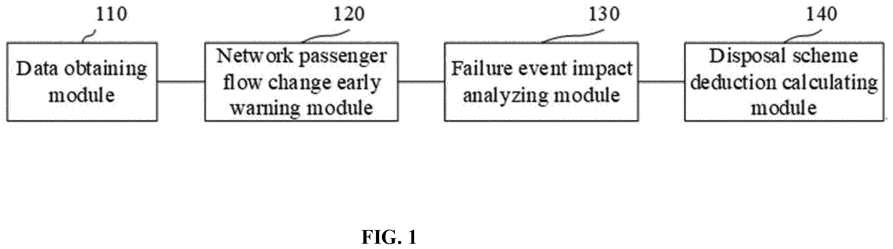

FIG. 1 is a schematic structural diagram of a system for rail transit parallel deduction according to an embodiment of the present application. The system includes a data obtaining module 110, a network passenger flow change early warning module 120, a failure event impact analyzing module 130 and a disposal scheme deduction calculating module 140.

The data obtaining module 110 is used to obtain real-time train operation data and real-time passenger flow data for a target line.

In order to predict various conditions for line operation in advance, deduce various impacts of adjusted schemes on operation in advance, and accurately select the optimum scheme, it is necessary to use on-site environmental data of rail transit, that is, it is necessary to obtain the real-time train operation data and the real-time passenger flow data for the target line.

In an embodiment, the source of data can be flexibly selected based on different requirements for accuracy and speed of deduction.

The network passenger flow change early warning module 120 is used to calculate real-time passenger flow spatial-temporal distribution corresponding to the target line based on historical passenger flow data and the real-time passenger flow data for the target line, and predict a passenger flow situation for the target line based on the real-time passenger flow spatial-temporal distribution.

In case of a normal operation situation of rail transit trains, the real-time passenger flow spatial-temporal distribution corresponding to the target line can be calculated based on the historical passenger flow data and the real-time passenger flow data for the target line, and then the passenger flow situation for the target line can be predicted based on the real-time passenger flow spatial-temporal distribution.

In an embodiment, a prediction of the passenger flow situation for the target line includes prediction of a short-time and short-period passenger flow, prediction of a large passenger flow and/or prediction of a sudden large passenger flow.

In an embodiment, in case that there will be a large passenger flow or a sudden large passenger flow through prediction, early warning information is sent to a user.

The failure event impact analyzing module 130 is used to, in case that a sudden failure occurs for the target line, determine an impact of the sudden failure on line operation and output index data associated with driving operation.

By using the failure event impact analyzing module, for a sudden failure, train operation states, traffic flow and passenger flow situations for the target line in the future time of period can be quickly deduced without intervention, and then the impact of the sudden failure of the target line on line operation can be determined and the index data associated with driving operation can be outputted. For example, based on association information of the failure and on-site real-time data, an impact point and an impact scope of the failure, and an impact of the failure on operating organization in case that the failure is not coped can be quickly deduced, such as a time for which train delays, train delay rate and passenger retention rate etc.

The disposal scheme deduction calculating module 140 is used to, in case that a sudden large passenger flow, a sudden failure or an emergency event occurs for the target line, deduce different disposal schemes for the sudden large passenger flow, the sudden failure or the emergency event, determine impacts of each disposal scheme on driving operation, passenger flow and traffic flow for the target line, perform energy consumption analysis, and output indexing data corresponding to each disposal scheme.

In an embodiment, in case that the sudden large passenger flow, the sudden failure or the emergency event occurs for the target line, it is necessary to make a decision and generate a disposal scheme for adjusting operation in a short time. In the embodiment of the present application, by deducing different disposal schemes, determining impacts of each disposal scheme on driving operation, passenger flow and traffic flow for the target line, performing energy consumption analysis, and outputting indexing data corresponding to each disposal scheme, the corresponding operation adjustment effects of each disposal scheme can be obtained for the dispatchers to choose the optimum scheme, where the indexing data include index data associated with driving operation, index data associated with passenger flow and energy consumption index data.

In the embodiment of the present application, by collecting operation states in real time, quickly deducing future operation states of lines under different scenes and different schemes based on the input of real-time data and real-time solutions, and outputting index data, a scientific support can be provided for real-time scheduling decisions.

On the basis of the above-mentioned embodiments, according to the system for rail transit parallel deduction of an embodiment of the present application, the disposal scheme deduction calculating module 140 further includes:
an operation simulating sub-module, used to, based on a disposal scheme inputted by a user or other systems, real-time train operation data and a train operation model, gradually deduce in terms of a preset time period, the index data associated with driving operation corresponding to a next preset time period for the target line under a current disposal scheme;
a passenger flow simulating sub-module, used to, based on a disposal scheme inputted by a user or other systems, real-time train operation data and a passenger flow stimulating model, gradually deduce in terms of a preset time period, the index data associated with passenger flow corresponding to a next preset time period for the target line under the current disposal scheme; and
an energy consumption analyzing sub-module, used to, based on a disposal scheme inputted by a user or other systems, real-time train operation data and an energy consumption model, gradually deduce in terms of a preset time period, energy consumption index data corresponding to a next preset time period for the target line under the current disposal scheme.

In an embodiment, the length of the preset time period may be preset by the user, or may be a default time length in the system.

The operation simulating sub-module mainly deduces, based on the disposal scheme inputted by the user or other systems, real-time train operation data and the model data, the state of the rail transit at next step under the current disposal scheme in terms of time, where the model data is a train operation model. Continuous deduction of multiple times constitutes continuous development of the current time, and future operation states of lines can be shown to the user based on the current disposal scheme, and an impact of the current disposal scheme on driving operation for the target line can be obtained.

The passenger flow simulating sub-module is mainly used to, based on the disposal scheme inputted by the user or other systems, real-time train operation data and the passenger flow stimulating model, gradually deduce, based on the preset time period, the index data associated with passenger flow corresponding to the next preset time period for the target line under the current disposal scheme, and an impact of the current disposal scheme on passenger flow for the target line can be obtained. The index data associated with passenger flow include passenger flow carrying rate.

The energy consumption analyzing sub-module mainly used to, based on the disposal scheme inputted by a user or other systems, real-time train operation data and the energy consumption model, gradually deduce in terms of a preset time period, energy consumption index data corresponding to the next preset time period for the target line under the current disposal scheme, and an impact of the current disposal scheme on energy consumption for the target line can be obtained.

In the embodiment of the present application, by collecting operation states from real world in real time, and quickly deducing future operation states, passenger flow situation and traffic flow situation for lines under different scenes and different schemes based on the input of real-time data and real-time solutions, a scientific support for real-time scheduling decisions can be provided to make the scheduling decision do not deviate from the actual scenes.

On the basis of the above-mentioned embodiments, the system for rail transit parallel deduction of an embodiment of the present application further includes:
an indicator evaluation sub-module, used to, based on the indexing data corresponding to each disposal scheme and index data for operation demand, evaluate each disposal scheme and output evaluation results corresponding to each disposal scheme.

In an embodiment, the index data for operation demand includes: index data associated with driving operation, index data associated with passenger flow, and energy consumption index data.

Based on the indexing data corresponding to each disposal scheme and index data for operation demand, each disposal scheme is evaluated, and evaluation results corresponding to each disposal scheme are outputted. The operator can directly determine the optimum disposal scheme based on the evaluation results, and the optimum disposal scheme does not deviate from the actual scenes.

Based on the above-mentioned embodiments, the system for rail transit parallel deduction further includes:
a user interface module, used to interact with the user;
a data storage module, used to store the real-time train operation data, the real-time passenger flow data, disposal schemes and model data; and
a scheme managing module, used to manage the disposal schemes.

The user interface module is used to receive user input, and display an organization process of the disposal scheme, content of the current disposal scheme, an operation process of the deduction for the current disposal scheme, and the indexing data corresponding to the current disposal scheme etc.

The data storage module is used to store the real-time train operation data, the real-time passenger flow data, the disposal schemes and the model data and provide interfaces for storage, query and update. The model data includes train operation model, passenger flow stimulating model and energy consumption model.

The scheme managing module is used to manage the disposal schemes, and it mainly implements functions of establishing, modifying, saving, loading, and querying the disposal schemes. The scheme managing module is in charge of interfaces with a user interface layer and a data storage layer. The scheme managing module also serves as the core of an application layer and can schedule other interface modules.

In an embodiment, the system for rail transit parallel deduction further includes: a model updating module, used to update the model used in simulated operation based on the actual operation data and data generated by the simulated operation.

In an embodiment, the system for rail transit parallel deduction according to the embodiments of the present application includes three layers: 1) a user interface (UI) layer, including the user interface module, which is used to interact with the user, and the user can input an operation scheme and check index data of the corresponding operation scheme through the UI layer; 2) an application layer, used to manage the schemes, and perform parallel deduction for the scheme, an impact on passenger flow, simulated operation, energy consumption analysis and model self-update, including the scheme managing module, operation simulating sub-module, passenger flow simulating sub-module, energy consumption analyzing sub-module, indicator evaluation sub-module, network passenger flow change early warning module, failure event impact analyzing module; and 3) a data storage layer, used to save models, data including indicators.

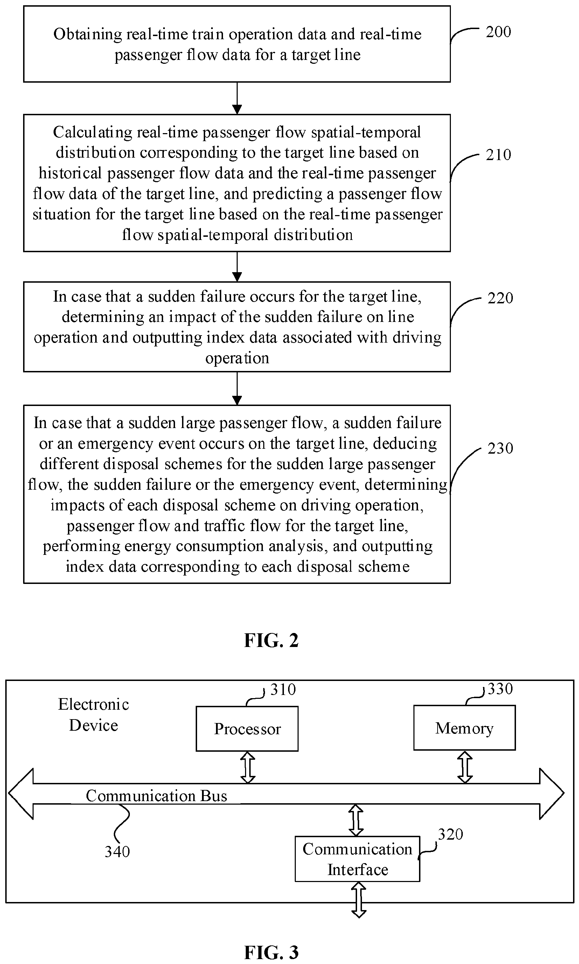

FIG. 2 is a schematic flow chart of a method for rail transit parallel deduction according to an embodiment of the present application. The method includes the following steps.

Step 200: obtaining real-time train operation data and real-time passenger flow data for a target line.

In order to predict various conditions for line operation in advance, deduce various impacts of adjusted schemes on operation in advance, and accurately select the optimum scheme, it is necessary to use on-site environmental data of rail transit, that is, it is necessary to obtain the real-time train operation data and the real-time passenger flow data for the target line.

In an embodiment, the source of data can be flexibly selected based on different requirements for accuracy and speed of deduction.

Step 210: calculating real-time passenger flow spatial-temporal distribution corresponding to the target line based on historical passenger flow data and the real-time passenger flow data for the target line, and predicting a passenger flow situation for the target line based on the real-time passenger flow spatial-temporal distribution.

In case of a normal operation situation of rail transit trains, the real-time passenger flow spatial-temporal distribution corresponding to the target line can be calculated based on the historical passenger flow data and the real-time passenger flow data for the target line, and then the passenger flow situation for the target line can be predicted based on the real-time passenger flow spatial-temporal distribution.

In an embodiment, a prediction of the passenger flow situation for the target line includes prediction of a short-time and short-period passenger flow, prediction of a large passenger flow and/or prediction of a sudden large passenger flow.

In an embodiment, in case that there will be a large passenger flow or a sudden large passenger flow through prediction, early warning information is sent to a user.

Step 220: in case that a sudden failure occurs for the target line, determining an impact of the sudden failure on line operation and outputting index data associated with driving operation.

By using the failure event impact analyzing module, for a sudden failure, train operation states, traffic flow and passenger flow situations for the target line in the future can be quickly deduced without intervention, and then the impact of the sudden failure of the target line on line operation can be determined and the index data associated with driving operation can be outputted. For example, based on association information of the failure and on-site real-time data, an impact point and an impact scope of the failure, and an impact of the failure on operating organization in case that the failure is not coped can be quickly deduced, such as a time for which train delays, train delay rate and passenger retention rate etc.

Step 230: in case that a sudden large passenger flow, a sudden failure or an emergency event occurs for the target line, deducing different disposal schemes for the sudden large passenger flow, the sudden failure or the emergency event, determining impacts of each disposal scheme on driving operation, passenger flow and traffic flow for the target line, performing energy consumption analysis, and outputting the indexing data corresponding to each disposal scheme.

In an embodiment, in case that the sudden large passenger flow, the sudden failure or the emergency event occurs for the target line, it is necessary to make a decision and generate a disposal scheme for adjusting operation in a short time. In the embodiment of the present application, by deducing different disposal schemes, determining impacts of each disposal scheme on driving operation, passenger flow and traffic flow for the target line, performing energy consumption analysis, and outputting the indexing data corresponding to each disposal scheme, the corresponding operation adjustment effects of each disposal scheme can be obtained for the dispatchers to choose the optimum scheme, where the indexing data include index data associated with driving operation, index data associated with passenger flow and energy consumption index data,.

In the embodiment of the present application, by collecting operation states from real world in real time, quickly deducing future operation states of lines under different scenes and different schemes based on the input of real-time data and real-time solutions, and outputting index data, a scientific support can be provided for real-time scheduling decisions.

In an embodiment, according to the method for rail transit parallel deduction of an embodiment of the present application, the in case that the sudden large passenger flow, the sudden failure or the emergency event occurs for the target line, deducing different disposal schemes for the sudden large passenger flow, the sudden failure or the emergency event, determining impacts of each disposal scheme on driving operation, passenger flow and traffic flow for the target line, performing energy consumption analysis, and outputting the indexing data corresponding to each disposal scheme, includes:
based on a disposal scheme inputted by a user or other systems, real-time train operation data and a train operation model, gradually deducing in terms of a preset time period, the index data associated with driving operation corresponding to a next preset time period for the target line under a current disposal scheme;
based on a disposal scheme inputted by a user or other systems, real-time train operation data and a passenger flow stimulating model, gradually deducing in terms of a preset time period, the index data associated with passenger flow corresponding to a next preset time period for the target line under the current disposal scheme; and
based on a disposal scheme inputted by a user or other systems, real-time train operation data and an energy consumption model, gradually deducing in terms of a preset time period, energy consumption index data corresponding to a next preset time period for the target line under the current disposal scheme.

In an embodiment, the length of the preset time period may be preset by the user, or may be a default time length in the system.

Based on the disposal scheme inputted by the user or other systems, real-time train operation data and the model data, the state of the rail transit at next step under the current disposal scheme is deduced in terms of time, where the model data is the train operation model. Continuous deduction of multiple times constitutes continuous development of the current time, and future operation states of lines can be shown to the user based on the current disposal scheme, and an impact of the current disposal scheme on driving operation for the target line can be obtained.

Based on the disposal scheme inputted by the user or other systems, real-time train operation data and the passenger flow stimulating model, the index data associated with passenger flow corresponding to the next preset time period for the target line under the current disposal scheme is gradually deduced in terms of a preset time period, and an impact of the current disposal scheme on passenger flow for the target line can be obtained. The index data associated with passenger flow include passenger flow carrying rate.

Based on the disposal scheme inputted by a user or other systems, real-time train operation data and the energy consumption model, energy consumption index data corresponding to the next preset time period for the target line under the current disposal scheme is gradually deduced in terms of a preset time period, and an impact of the current disposal scheme on energy consumption for the target line can be obtained.

In the embodiment of the present application, by collecting operation states from real world in real time, quickly deducing future operation states of lines under different scenes and different schemes based on the input of real-time data and real-time solutions, and outputting index data, a scientific support can be provided for real-time scheduling decisions, which does not deviate from the actual scenes.

In an embodiment, the method for rail transit parallel deduction according to an embodiment of the present application further includes:
based on the indexing data corresponding to each disposal scheme and index data for operation demand, evaluating each disposal scheme and outputting evaluation results corresponding to each disposal scheme.

In an embodiment, the operation demand index data includes: index data associated with driving operation, index data associated with passenger flow, and energy consumption index data.

Based on the indexing data corresponding to each disposal scheme and index data for operation demand, each disposal scheme is evaluated, and evaluation results corresponding to each disposal scheme are outputted. The operator can directly determine the optimum disposal scheme based on the evaluation results, and the optimum disposal scheme does not deviate from the actual scenes.

FIG. 3 is a schematic diagram of a physical structure of an electronic device according to an embodiment of the present application. As shown in FIG. 3, the electronic device includes: a processor 310, a communication interface 320, a memory 330, and a communication bus 340. The processor 310, the communication interface 320, and the memory 330 communicate with each other through the communication bus 340. The processor 310 can call a logic instruction stored on the memory 330 to perform a method for rail transit parallel deduction. The method includes the following steps:
obtaining real-time train operation data and real-time passenger flow data for a target line;
calculating real-time passenger flow spatial-temporal distribution corresponding to the target line based on historical passenger flow data and the real-time passenger flow data for the target line, and predicting a passenger flow situation for the target line based on the real-time passenger flow spatial-temporal distribution;
in case that a sudden failure occurs for the target line, determining an impact of the sudden failure on line operation and outputting index data associated with driving operation; and
in case that a sudden large passenger flow, a sudden failure or an emergency event occurs for the target line, deducing different disposal schemes for the sudden large passenger flow, the sudden failure or the emergency event, determining impacts of each disposal scheme on driving operation, passenger flow and traffic flow for the target line, performing energy consumption analysis, and outputting indexing data corresponding to each disposal scheme.

In addition, the above-mentioned logic instructions in the memory 330 can be implemented in the form of software function units and be stored in a computer-readable storage medium when sold or used as an individual product. Based on such understanding, the solutions of the present application in essential or the part of the solutions that contributes to the related art or the part of the solutions can be embodied in the form of a software product, and the computer software product can be stored in a storage medium, including several instructions, which are used to make a computer device (which can be a personal computer, a server, or a network device and the like) execute all or part of the steps of the methods described in the various embodiments of the present application. The aforementioned storage media include: USB flash disk, mobile hard disk, read-only memory (ROM), random access memory (RAM), magnetic disk or optical disk, and other media that can store program codes.

An embodiment of the present application provides a computer program product. The computer program product includes a computer program stored on a non-transitory computer-readable storage medium. The computer program includes program instructions, and the program instructions, when executed by a computer, cause the computer to execute the method for rail transit parallel deduction according to the above-mentioned method embodiments. The method includes the following steps:
obtaining real-time train operation data and real-time passenger flow data for a target line;
calculating real-time passenger flow spatial-temporal distribution corresponding to the target line based on historical passenger flow data and the real-time passenger flow data for the target line, and predicting a passenger flow situation for the target line based on the real-time passenger flow spatial-temporal distribution;
in case that a sudden failure occurs for the target line, determining an impact of the sudden failure on line operation and outputting index data associated with driving operation; and
in case that a sudden large passenger flow, a sudden failure or an emergency event occurs for the target line, deducing different disposal schemes for the sudden large passenger flow, the sudden failure or the emergency event, determining impacts of each disposal scheme on driving operation, passenger flow and traffic flow for the target line, performing energy consumption analysis, and outputting indexing data corresponding to each disposal scheme.

An embodiment of the present application provides a non-transitory computer-readable storage medium having a computer program stored thereon, and the computer program, when executed by a processor, causes the processor to execute the method for rail transit parallel deduction according to the above-mentioned method embodiments. The method includes the following steps:
obtaining real-time train operation data and real-time passenger flow data for a target line;
calculating real-time passenger flow spatial-temporal distribution corresponding to the target line based on historical passenger flow data and the real-time passenger flow data for the target line, and predicting a passenger flow situation for the target line based on the real-time passenger flow spatial-temporal distribution;
in case that a sudden failure occurs for the target line, determining an impact of the sudden failure on line operation and outputting index data associated with driving operation;
in case that a sudden large passenger flow, a sudden failure or an emergency event occurs for the target line, deducing different disposal schemes for the sudden large passenger flow, the sudden failure or the emergency event, determining impacts of each disposal scheme on driving operation, passenger flow and traffic flow for the target line, performing energy consumption analysis, and outputting indexing data corresponding to each disposal scheme.

The device embodiments described above are merely illustrative, the units described as separate components may or may not be physically separate, and the components displayed as units may or may not be physical units, and they may be located at the same place or may be distributed to multiple network units. Some or all of the modules may be selected according to actual needs to achieve the purpose of the solution of the present embodiment. Those of ordinary skill in the art can understand and implement the solution described above without paying creative works.

Through the description of the embodiments above, those skilled in the art can clearly understand that the various embodiments can be implemented by means of software and a necessary general hardware platform, or by hardware. Based on such understanding, the above solutions of the present application in essence or a part of the solutions that contributes to the related art can be embodied in the form of a software product, which can be stored in a computer readable storage medium such as ROM/RAM, magnetic disk, compact disk and the like, and including several instructions to cause a computer device (which can be a personal computer, server, network device and the like) to perform the methods described in various embodiments or a part thereof.

Finally, it should be noted that the above embodiments are only used to explain the solutions of the present application, and are not to limited them. Although the present application has been described in detail with reference to the foregoing embodiments, it should be understood by those skilled in the art that they can still modify the solutions documented in the foregoing embodiments and make equivalent substitutions to a part of the features; these modifications and substitutions do not make the essence of the corresponding solutions depart from the scope of the solutions of various embodiments of the present application.

## Claims

1. A system for rail transit parallel deduction, comprising:
a data obtaining module, used to obtain real-time train operation data and real-time passenger flow data for a target line;
a network passenger flow change early warning module, used to calculate real-time passenger flow spatial-temporal distribution corresponding to the target line based on historical passenger flow data and the real-time passenger flow data for the target line, and predict a passenger flow situation for the target line based on the real-time passenger flow spatial-temporal distribution;
a failure event impact analyzing module, used to, in case that a sudden failure occurs for the target line, determine an impact of the sudden failure on line operation and output index data associated with driving operation; and
a disposal scheme deduction calculating module, used to, in case that a sudden large passenger flow, a sudden failure or an emergency event occurs for the target line, deduce different disposal schemes for the sudden large passenger flow, the sudden failure or the emergency event, determine impacts of each disposal scheme on driving operation, passenger flow and traffic flow for the target line, perform energy consumption analysis, and output indexing data corresponding to each disposal scheme.

2. The system of claim 1, wherein the disposal scheme deduction calculating module comprises:
an operation simulating sub-module, used to, based on a disposal scheme inputted by a user or other systems, real-time train operation data and a train operation model, gradually deduce in terms of a preset time period, the index data associated with driving operation corresponding to a next preset time period for the target line under a current disposal scheme;
a passenger flow simulating sub-module, used to, based on a disposal scheme inputted by a user or other systems, real-time train operation data and a passenger flow stimulating model, gradually deduce in terms of a preset time period, the index data associated with passenger flow corresponding to a next preset time period for the target line under the current disposal scheme; and
an energy consumption analyzing sub-module, used to, based on a disposal scheme inputted by a user or other systems, real-time train operation data and an energy consumption model, gradually deduce in terms of a preset time period, energy consumption index data corresponding to a next preset time period for the target line under the current disposal scheme.

3. The system of claim 2, wherein the disposal scheme deduction calculating module further comprises:
an indicator evaluation sub-module, used to, based on the indexing data corresponding to each disposal scheme and index data for operation demand, evaluate each disposal scheme and output evaluation results corresponding to each disposal scheme.

4. The system of claim 3, further comprising:
a user interface module, used to interact with the user;
a data storage module, used to store the real-time train operation data, the real-time passenger flow data, disposal schemes and model data; and
a scheme managing module, used to manage the disposal schemes.

5. A method for rail transit parallel deduction, comprising:
obtaining real-time train operation data and real-time passenger flow data for a target line;
calculating real-time passenger flow spatial-temporal distribution corresponding to the target line based on historical passenger flow data and the real-time passenger flow data for the target line, and predicting a passenger flow situation for the target line based on the real-time passenger flow spatial-temporal distribution;
in case that a sudden failure occurs for the target line, determining an impact of the sudden failure on line operation and outputting index data associated with driving operation; and
in case that a sudden large passenger flow, a sudden failure or an emergency event occurs for the target line, deducing different disposal schemes for the sudden large passenger flow, the sudden failure or the emergency event, determining impacts of each disposal scheme on driving operation, passenger flow and traffic flow for the target line, performing energy consumption analysis, and outputting indexing data corresponding to each disposal scheme.

6. The method of claim 5, wherein the in case that the sudden large passenger flow, the sudden failure or the emergency event occurs for the target line, deducing different disposal schemes for the sudden large passenger flow, the sudden failure or the emergency event, determining impacts of each disposal scheme on driving operation, passenger flow and traffic flow for the target line, performing energy consumption analysis, and outputting indexing data corresponding to each disposal scheme, comprises:
based on a disposal scheme inputted by a user or other systems, real-time train operation data and a train operation model, gradually deducing in terms of a preset time period, the index data associated with driving operation corresponding to a next preset time period for the target line under a current disposal scheme;
based on a disposal scheme inputted by a user or other systems, real-time train operation data and a passenger flow stimulating model, gradually deducing in terms of a preset time period, the index data associated with passenger flow corresponding to a next preset time period for the target line under the current disposal scheme; and
based on a disposal scheme inputted by a user or other systems, real-time train operation data and an energy consumption model, gradually deducing in terms of a preset time period, energy consumption index data corresponding to a next preset time period for the target line under the current disposal scheme.

7. The method of claim 6, further comprising:
based on the indexing data corresponding to each disposal scheme and index data for operation demand, evaluating each disposal scheme and outputting evaluation results corresponding to each disposal scheme.

8. An electronic device, comprising a memory, a processor, and a computer program stored on the memory and executable on the processor, wherein the computer program, when executed by the processor, causes the electronic device to execute steps of the method for rail transit parallel deduction according to any one of claims 5 to 7.

9. A non-transitory computer-readable storage medium, having a computer program stored thereon, and the computer program, when executed by a processor, causes the processor to execute steps of the method for rail transit parallel deduction according to any one of claims 5 to 7.
